(19) Europäisches Patentamt
European Patent Office
Office européen des brevets

(11) **EP 2 760 260 B1**

(12) **EUROPEAN PATENT SPECIFICATION**

(45) Date of publication and mention of the grant of the patent:
**09.11.2016 Bulletin 2016/45**

(21) Application number: **12834179.9**

(22) Date of filing: **11.09.2012**

(51) Int Cl.:
*H05K 3/00* *(2006.01)*    *C09K 13/02* *(2006.01)*
*H05K 3/38* *(2006.01)*

(86) International application number:
**PCT/JP2012/073201**

(87) International publication number:
**WO 2013/042582 (28.03.2013 Gazette 2013/13)**

(54) **DESMEAR SOLUTION AND DESMEAR METHOD**

ENTSCHMIERUNGSLÖSUNG UND ENTSCHMIERUNGSVERFAHREN

SOLUTION ET PROCÉDÉ DE DÉCAPAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.09.2011 JP 2011207031**

(43) Date of publication of application:
**30.07.2014 Bulletin 2014/31**

(73) Proprietor: **C. Uyemura & Co., Ltd.**
**Osaka-shi, Osaka 541-0045 (JP)**

(72) Inventors:
• **SAIJO, Yoshikazu**
**Hirakata-shi**
**Osaka 573-0065 (JP)**

• **YAMAMOTO, Hisamitsu**
**Hirakata-shi**
**Osaka 573-0065 (JP)**
• **UTSUMI, Masayuki**
**Hirakata-shi**
**Osaka 573-0065 (JP)**

(74) Representative: **Müller Hoffmann & Partner**
**Patentanwälte mbB**
**St.-Martin-Strasse 58**
**81541 München (DE)**

(56) References cited:
GB-A- 1 479 556          JP-A- H03 214 689
JP-A- S61 278 597       JP-A- 2002 124 753
JP-A- 2005 086 164     JP-A- 2010 182 925
US-A- 4 592 852          US-A1- 2008 299 402

EP 2 760 260 B1

**Description**

Field of the Invention

The present invention relates to a desmear solution and a desmear method, more specifically, relates to a desmear solution for etching a resin substrate in a desmear treatment for printed circuit boards and to a desmear method using said desmear solution.

Background of the Invention

When a through hole or a via hole is formed in a printed circuit board, a smear, that is resin debris, is generated by heat through friction between a drill, a laser, or the like and a resin of a substrate of the printed circuit board. To maintain an electrical property, the smear generated inside the through hole or the via hole needs to be removed, and accordingly a desmear treatment for removing the smear by a chemical method has been commonly used.

A most common desmear method uses a chemical solution (desmear solution) comprising a permanganate, such as sodium permanganate or potassium permanganate, and a caustic composite. Specifically, as the desmear solution comprising the permanganate and the caustic composite, a treatment solution comprising approximately 0.4 mol/L of a permanganate and approximately 1N of a caustic composite has been commonly used (For example, refer to Patent Literature 1).

Ordinary desmear treatments aim at certainly removing a smear generated inside a through hole or a via hole in a resin substrate and simultaneously at etching appropriately a surface of the resin substrate to form predetermined surface roughness. In other words, in the desmear treatment, there has been required both to remove a smear generated by the formation of a through hole or a via hole, thereby maintaining an electrical property of a printed circuit board, and to increase peel strength of a plating film formed on a resin substrate, thereby improving adhesion of the plating film.

However, although a desmear solution having a prior composition has a predetermined smear-removal effect, the solution causes a problem that etching proceeds even in a depth direction of a resin substrate, thereby excessively roughening the resin substrate. Therefore, the application of the desmear solution to a field requiring surface smoothness of a resin substrate has been limited. Furthermore, when such excessive roughening of the surface of a resin substrate causes a more decrease in an amount of resin, strength of the resin substrate itself is lowered, and peel strength of a plating film formed on the resin substrate is also lowered, whereby adhesion is considerably lost.

Furthermore, a permanganate contained in a desmear solution reacts with resin of a substrate, whereby heptavalent manganese is reduced to hexavalent manganese, and as mentioned above, the prior etching solution causes excessive etching to proceed to such a degree that a surface of a resin substrate is excessively roughened, and thus, a production amount of hexavalent manganese with respect to treatment time is large, and as a result, an etching rate has been remarkably decreased. To solve this problem, the hexavalent manganese is oxidized to heptavalent manganese by electrolytic oxidation to reproduce and recycle a permanganate, but, since the desmear solution having the prior composition causes a large amount of resin to be dissolved, a formation rate of hexavalent manganese is very high and a large amount of hexavalent manganese is produced for a short time, and accordingly a larger anode area for the electrolytic oxidation to heptavalent manganese has been needed.

On the other hand, for example, Patent Literature 2 discloses a desmear treatment using a desmear solution having a lower concentration of a permanganate. However, a technique disclosed in Patent Literature 2 is such that a through hole is formed with a laser in a substrate in which a copper metal layer is formed on an insulating layer, and a desmear treatment is given to the copper layer on a surface of the metal substrate. In other words, this technique aims at removing a smear on a surface of the copper layer of the substrate and a residue inside the through hole, not aiming at a desmear treatment for resin on a surface of the substrate, and Patent Literature 2 never discloses an idea that a smear is certainly removed and, at the same time, appropriate surface roughness is provided to a surface of a resin substrate in order that peel strength of a plating film formed on the resin surface is increased to improve adhesion of the plating film to the resin substrate.

Thus, there has been required a desmear treatment capable of both effectively removing a smear, that is resin debris, generated through the formation of a through hole or a via hole and simultaneously improving adhesion of a resin substrate to a plating film without excessive roughening of the resin substrate.

Prior-Art Documents

Patent Document

PTL 1: Japanese Patent Application Laid-Open No. 2004-282020
PTL 2: Japanese Patent Application Laid-Open No. 2001-135750

US 4,592,852 discloses a solution containing 30 g potassium permanganate and 25 g sodium hydroxide in a total volume of 500 ml. That is, the concentration of potassium permanganate is 0.38 mol/l and the concentration of sodium hydroxide is 1.25 mol/L resulting in a mole concentration ratio of permanganate to alkali metal hydroxide of 1:3.3.
GB 1 479 556, which relates to a method for cleaning hole walls to be provided with a metal layer, discloses an aqueous solution comprising from 10 to 75 g/l potassium permanganate, 0.01 to 0.5 g/l of a fluorinated hydrocarbon wetting agent and sodium hydroxide.

Summary of the Invention

The present invention is proposed in view of such actual circumstances, and aims at providing a desmear solution capable of both certainly removing a smear generated in a non-through hole formed in a resin substrate and forming a plating film excellent in adhesion without excessive roughening of the resin substrate surface; and at providing a desmear method using the desmear solution.
The present inventors earnestly studied to achieve the above-mentioned aim, and, as a result, found that, in a desmear solution containing a permanganate and an alkali metal hydroxide, when the permanganate has a concentration of 0.2 to 0.4 mol/L and also an amount of the alkali metal hydroxide contained is higher than an amount of the permanganate contained, a smear can be effectively removed and also adhesion of a plating film can be improved without excessive roughening of a resin substrate surface, and completed the present invention.
In other words, a desmear solution according to the present invention comprises a permanganate having a concentration of 0.2 to 0.4 mol/L and an alkali metal hydroxide and has a molar concentration ratio of said permanganate to said alkali metal hydroxide of 1:5 to 1:20.
A desmear method according to the present invention is a desmear method for a resin substrate with a non-through hole formed therein, the method using a desmear solution containing a permanganate having a concentration of 0.2 to 0.4 mol/L and an alkali metal hydroxide and having a molar concentration ratio of said permanganate to said alkali metal hydroxide of 1:5 to 1:20.

Effects of Invention

According to the present invention, a smear generated inside a through hole or a via hole can be certainly removed and also appropriate surface roughness can be provided without excessive roughening of a resin substrate, whereby a plating film excellent in adhesion can be formed.
Furthermore, the present invention makes it possible to control an amount of resin etched (an amount of resin decreased), and accordingly a production amount of hexavalent manganese of a permanganate in a desmear solution can be controlled, whereby a decrease in etching rate can be controlled and also a load of electrolytic oxidation to heptavalent manganese can be reduced.

Brief Description of Drawings

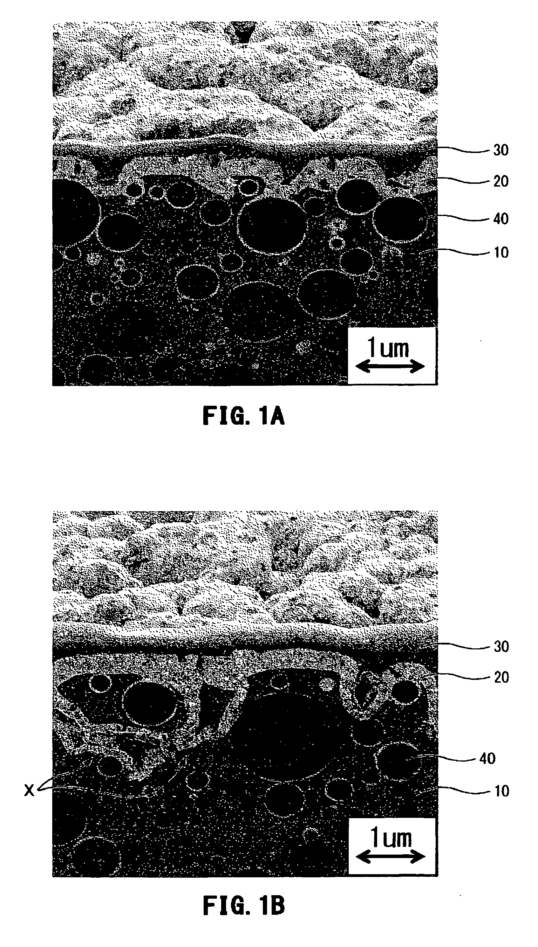

Figure 1 (A) is a SIM image of a part of a circuit board obtained by FIB cross-section processing thereof, the circuit board having undergone a desmear treatment using a desmear solution according to the present embodiment, and Figure 1 (B) is a SIM image of a part of a circuit board obtained by FIB cross-section processing thereof, the circuit board having undergone a desmear treatment using a prior desmear solution.

Detailed Description of the Invention

Hereinafter, a specific embodiment of a desmear solution and a desmear method using said desmear solution according to the present invention (hereinafter, referred to as the present embodiment) will be described in detail.

(Desmear solution)

The desmear solution according to the present embodiment is a desmear solution mainly used for desmearing of a resin substrate in which a blind through hole or a blind via hole is formed with a drill, a laser, or the like, the desmear solution being capable of certainly removing a smear generated inside such non-through hole and also forming a plating film having high adhesion strength to a resin substrate without excessive roughening of a surface of the resin substrate.

Specifically, the desmear solution according to the present embodiment comprises a permanganate having a concentration of 0.2 to 0.4 mol/L and an alkali metal hydroxide and has a molar concentration ratio of the permanganate to the alkali metal hydroxide of 1:5 to 1:20.

As the permanganate, a salt dissolved in an aqueous solution is beneficial, specifically, examples of the permanganate include sodium permanganate, potassium permanganate, and the like. These permanganates may be used alone, or two or more kinds of these may be used in combination.

Furthermore, in this desmear solution, the permanganate has a concentration of approximately 0.2 to 0.4 mol/L. When a permanganate content is less than 0.2 mol/L, a smear generated in a non-through hole, such as a blind through hole or a blind via hole, cannot be sufficiently removed and also appropriate surface roughness cannot be provided to a surface of a resin substrate, and accordingly, adhesion of the resin substrate to a plating film formed thereon is weaker. On the other hand, when a permanganate content is more than 0.4 mol/L, a surface of a resin substrate is excessively etched and roughened too much, and accordingly, strength of the resin substrate is weaker and adhesion of the resin substrate to a plating film is also weaker.

It should be noted that a smear, that is resin debris, generated inside a non-through hole, such as a blind through hole or a blind via hole, is dissolved and removed through an oxidation reaction by manganese of a permanganate as shown in the following reaction formula (1).

$$\text{Mn}^{7+} + \overline{(\text{C})} \rightarrow \text{Mn}^{6+} \quad \dots (1)$$

At this point, when the desmear solution comprises a high concentration of a permanganate, the above-mentioned reaction allows to proceed a smear to be dissolved and removed, but a resin substrate to be excessively etched, and thus a surface of the resin substrate to be excessively roughened. Such excessive roughening of a surface of a resin substrate leads to weaker strength of the resin substrate itself and also lowers adhesion of the resin substrate to a plating film formed on the surface of the substrate. Furthermore, the excessive roughening of a surface of a resin substrate sometimes causes a circuit pattern formed on the excessively-roughened resin substrate surface to fall down, and thus a serious problem arises under circumstances where wiring patterns have been finer in recent years. However, on the other hand, in view of adhesion of a resin substrate to a plating film formed thereon, it is important to provide appropriate surface roughness to a surface of a resin substrate, whereby peel strength of the plating film is increased and adhesion of the resin substrate to the plating film can be improved.

Therefore, there is provided the desmear solution according to the present embodiment, the desmear solution containing a permanganate and an alkali metal hydroxide as mentioned above, wherein the permanganate has a concentration of 0.2 to 0.4 mol/L and the concentration is lower than that of a permanganate in a prior desmear solution, and also an amount of the alkali metal hydroxide contained is larger than an amount of the permanganate contained. Specifically, the permanganate and the alkali metal hydroxide which constitute the desmear solution are contained so that a molar concentration ratio of the permanganate to the alkali metal hydroxide is 1:5 to 1:20.

Examples of the alkali metal hydroxide include sodium hydroxide, potassium hydroxide, and the like. Among these, sodium hydroxide has a higher solubility and does not easily crystallize, and therefore can be handled in the form of a concentrated solution, and hence, from a viewpoint of not requiring time and effort for dissolution and the like, sodium hydroxide is more preferable. Furthermore, the use of sodium hydroxide is highly effective in improving oxidizing power of manganese as mentioned later and allows a smear to be dissolved and removed more effectively. These alkali metal hydroxides may be used alone, or two or more kinds of these may be used in combination.

Furthermore, as mentioned above, the alkali metal hydroxide is made to be contained so that a molar concentration ratio of the permanganate having a concentration of 0.2 to 0.4 mol/L to the alkali metal hydroxide is 1:5 to 1:20 and an amount of the alkali metal hydroxide contained is higher than that of a permanganate contained.

Furthermore, it is more preferable to contain the permanganate having a concentration of 0.2 to 0.4 mol/L and the alkali metal hydroxide at a molar concentration ratio of 1:10 to 1:20. As mentioned later in detail, this allows an oxidizing power of the permanganate over resin to be further increased and a smear to be more certainly dissolved and removed with excessive roughening of a surface of a resin substrate being controlled.

Here, Fig. 1 (A) shows that a SIM (Scanning Ion Microscope) image of a part of a circuit board cross-section-processed by FIB (Focused Ion Beam), the circuit board being obtained such that a desmear treatment using a desmear solution according to the present embodiment is provided to a surface of an insulating resin 10 and then a plating film 20 is formed and a carbon layer 30 is mounted thereon. On the other hand, Fig. 1 (B) shows that a SIM image of a circuit board cross-section-processed by FIB, the circuit board being packaged after a desmear treatment using a prior desmear solution. It should be noted that a portion indicated by a reference sign 40 in Fig. 1 is a filler in the resin.

As shown in Fig. 1 (A), the surface of the insulating resin 10 to which the desmear treatment using the desmear solution according to the present embodiment is provided is not excessively roughened and has appropriate surface roughness, and the plating film 20 is formed thereon. On the other hand, as shown in Fig. 1

(B), in the case where the desmear treatment is performed using the prior desmear solution, the surface of the insulating resin 10 is excessively etched, and as a result,
as indicated by an arrow X in the Fig. 1 (B), the insulating resin 10 is etched to the deep position thereof and the resin substrate is excessively roughened.

In other words, in the case of using the prior desmear solution, when a surface of a resin substrate is etched at the early stage of a desmear treatment, after that, etching further proceeds in a depth direction of the resin substrate. In this case, a smear generated inside a non-through hole, such as a blind through hole or a blind via hole, is removed, but, as shown in Fig. 1 (B), the resin substrate is excessively roughened to a deep position thereof. Thus, strength of the resin itself is weaker, and also, peel strength of the plating film formed on the resin substrate is weaker, and consequently, adhesion is considerably lost.

On the other hand, in the case when the desmear solution according to the present embodiment is used, the permanganate has a concentration of approximately 0.2 to 0.4 mol/L, and also the permanganate and the alkali metal hydroxide are contained so that a molar concentration ratio of the permanganate to the alkali metal hydroxide is 1:5 to 1:20, and thus an amount of the alkali metal hydroxide contained is larger than an amount of the permanganate contained. Therefore, once a surface of a resin substrate is etched at an early stage of the desmear treatment, etching does not further proceed, and accordingly, unlike the case of using the prior desmear solution, the resin substrate is not excessively etched in the depth direction thereof. In other words, small and shallow etching is performed for the surface of the resin substrate, and thus, without excessive roughening of the surface of the resin substrate, appropriate surface roughness can be provided to the surface thereof.

Also, in the desmear solution according to the present embodiment, the permanganate has a concentration of approximately 0.2 to 0.4 mol/L while an amount of the alkali metal hydroxide contained is larger than an amount of the permanganate contained, and therefore the higher alkali concentration in the desmear solution makes it possible to increase oxidation power of manganese shown in the above-mentioned reaction formula (1), whereby appropriate surface roughness is provided and also a smear generated inside a non-through hole, such as a blind through hole or a blind via hole, can be certainly removed.

Thus, the desmear solution according to the present embodiment causes a reaction expressed in the above-mentioned reaction formula (1) as is the case with the prior desmear solution, but has a lower concentration of a permanganate to reduce an absolute amount for the reaction while the desmear solution contains a larger amount of an alkali metal hydroxide than the permanganate to improve oxidation power of manganese over resin. Thus, while an action to certainly dissolve and remove a smear is maintained, excessive etching to a resin substrate is controlled, and thus a surface of the resin substrate can be prevented from being excessively roughened. Furthermore, no excessive roughening of the resin surface allows an amount of the resin substrate decreased to be controlled and the strength of the resin substrate itself to be maintained. Also, since appropriate surface roughness can be provided, adhesion of the resin substrate to the plating film can be improved.

Moreover, the desmear solution according to the present embodiment allows an absolute amount of the reaction by the permanganate (etching amount) to be decreased as mentioned above, and therefore a production amount of hexavalent manganese can be reduced. Thus, in electrolytic oxidation for reproducing heptavalent manganese from hexavalent manganese which has been conventionally performed a measure, for example, to increase an anode area is no longer needed, and also the number of times of electrolysis can be reduced, and accordingly a desmear solution can be efficiently used.

Furthermore, the desmear solution according to the present embodiment can prevent a finer pattern from falling down, thereby allowing a stable circuit pattern to be formed. In other words, in recent years, electronic components have been more and more miniaturized, and accordingly a finer circuit pattern has been required, specifically, a pattern having a L/S of 50/50, 20/20, or 10/10 has been required. Under such circumstance, if a surface of a resin substrate is excessively roughened as is the case with the use of the prior desmear solution (refer to Fig. 1(B)), there arises a possibility that a fine pattern formed on the resin substrate may fall down due to a so-called hole (roughness) caused by etching. On the other hand, as shown in Fig. 1 (A), the desmear solution according to the present embodiment does not excessively roughen the surface of a resin substrate and provides appropriate surface roughness, and therefore, even a finer pattern does not fall down and is stably maintained, whereby wiring failure, such as wire disconnection and short circuit, can be prevented.

Also, in mounting of a circuit board, in some cases, patterning by photoresist is performed for a plating film formed on a resin substrate to which a desmear treatment is given, and then etching is performed in order to prevent short-circuit. At this point, if a surface of the resin substrate is excessively roughened as is the case with the use of the prior desmear solution, a residue of the etching performed for preventing short-circuit sometimes enters and remains inside a hole (roughness) formed in a depth direction of the resin substrate. In this case, the remaining etching residue may cause short-circuit between wirings. On the other hand, the desmear solution according to the present embodiment does not excessively roughen a surface of a resin substrate, and therefore, there is no concern about the possibility of an etching residue entering and even if the residue enters, it can be easily removed, and thus short-circuit between wirings and the like can be effectively prevented.

Furthermore, as mentioned above, the desmear solution according to the present embodiment has a lower concentration of a permanganate than the prior desmear solution does, and therefore an amount of expensive manganese used can be controlled, and also from an economical viewpoint, a desmear treatment can be more efficiently performed.

(Desmear method)

Next, a desmear method using the above-mentioned desmear solution will be explained. The desmear method according to the present embodiment is provided mainly to a resin substrate in which a blind through hole or a blind via hole is formed with a drill, a laser, or the like; and applied to a desmear treatment aiming at removing a smear, that is resin debris, generated inside the non-through hole and also aiming at providing appropriate surface roughness to the surface of the resin substrate thereby aiming at increasing adhesion of the surface of the resin substrate to a plating film formed thereon.

Specifically, the desmear method comprises a swelling step and a roughening step (etching step).

First, in the swelling step, swelling is performed in such a manner that, for example, a swelling solution containing organic compounds, such as N-methyl-2-pyrrolidone, N,N-dimethylacetamide, N,N-dimethylformamide, and gamma-butyrolactone, at a predetermined composition is used, and a resin substrate in which a non-through hole is formed with a laser or the like is immersed in the swelling solution at a predetermined time. The swelling treatment is thus performed for the resin substrate, whereby a smear can be easily removed in the downstream step, that is, the roughening step. Furthermore, the swelling of the resin substrate allows adhesion of the resin substrate to a plating film obtained through the roughening step to be further improved.

A treatment time of the swelling is not particularly limited, but preferably approximately 30 seconds to 15 minutes, more preferably approximately 1 to 10 minutes. A treatment temperature depends on a kind, an amount, or the like of the organic compound contained in the swelling solution, but, may be approximately 40 to 90 degrees C.

Next, in the roughening step, a smear, that is resin debris, remaining inside a non-through hole formed in a resin substrate is dissolved and removed. Also, in this roughening step, a surface of the resin substrate is etched to have appropriate surface roughness, whereby peel strength of a plating film to be formed on the resin substrate is increased, thereby improving adhesion.

Here, especially in a non-through hole formed in a resin substrate, a smear easily accumulates and needs to be certainly removed by the roughening in the desmear method. On the other hand, in this roughening step, in order to manufacture a printed circuit board of good quality, it is important both to certainly remove a smear as mentioned above and to increase peel strength of a plating film formed on the resin substrate thereby to improve adhesion. From a viewpoint of smear removal, a predetermined effect of smear removal can be achieved by using a desmear solution having a higher concentration of a permanganate as is the case with the prior art or by applying a higher reaction temperature. However, in a treatment using the prior desmear solution, a resin substrate in contact with a plating film is excessively dissolved, whereby a surface of the resin substrate is excessively roughened, and thus, strength of the resin substrate is weakened and also adhesion of the resin substrate to the plating film is reduced.

Therefore, in the desmear method according to the present embodiment, roughening is performed using a desmear solution containing a permanganate and an alkali metal hydroxide, wherein the permanganate has a concentration of 0.2 to 0.4 mol/L and a molar concentration ratio of the permanganate to the alkali metal hydroxide is 1:5 to 1:20. Thus, in the desmear method according to the present embodiment, roughening is performed using the desmear solution in which 0.2 to 0.4 mol/L of the permanganate is contained and an amount of the alkali metal hydroxide contained is larger than an amount of the permanganate contained, whereby an absolute amount of manganese reacting with resin is reduced while oxidation power of the manganese over the resin is improved.

This desmear method makes it possible to certainly dissolve and remove a smear accumulating in a non-through hole and also to control excessive etching to a resin substrate, thereby preventing excessive roughening of the surface thereof, whereby appropriate roughness can be provided to the surface of the resin substrate. Furthermore, since the surface of the resin substrate is not excessively roughened, an amount of the resin substrate decreased can be controlled and strength of the resin substrate itself can be maintained. Also, since appropriate surface roughness can be provided, peel strength of the plating film from the resin substrate can be increased, whereby adhesion of the resin substrate to the plating film can be improved.

A temperature condition for this desmear method varies depending on an insulating resin to be used, but for example may be in a range of approximately 65 degrees C to 75 degrees C. This temperature condition is relatively lower than a temperature condition for a prior desmear treatment (approximately 80 degrees C). In this respect, the cost for raising a temperature of the desmear solution can be held down, whereby the treatment can be efficiently performed. In the desmear method according to the present embodiment, a relatively low temperature condition, that is, approximately 65 degrees C to 70 degrees C, is applied, and thus a surface of a resin substrate is not excessively roughened, while peel strength of a plating film is increased, whereby adhesion of the resin substrate to a plating film can be improved.

As to a resin substrate to which the desmear method according to the present embodiment is applicable, an insulating resin material constituting this resin substrate is not particularly limited and a well-known insulating resin material may be used. Specifically, examples of the insulating resin material include epoxy resin, polyimide resin, bismaleimide-triazine resin, polyphenylene ether resin, phenol resin, and fluororesin, and furthermore, a material obtained by impregnating a glass cloth with the above-mentioned resin may be beneficial and a reinforcing base material other than glass may be also beneficial. Furthermore, liquid crystal polymer, that is a thermoplastic resin film, polyetheretherketone resin, polyetherimide resin, polyethersulfone resin, and the like may be also used as an insulating resin material.

A method of forming a non-through hole in a resin substrate is not particularly limited, and may be drilling, laser irradiation, punching, or the like, but, from a viewpoint of micromachining or productivity, a method using laser irradiation is more preferable. As to a laser, a laser having a transmission wavelength in an infrared region, such as carbon dioxide laser or YAG laser, may be used as it is, or 260 to 400 nm of ultraviolet light extracted by irradiating a nonlinear type optical crystal with the laser may be used.

Moreover, the resin substrate is not particularly limited, but, a resin substrate a whole surface of which except a surface of a non-through hole formed therein is coated with the above-mentioned insulating resin material may be used. In other words, there may be used a resin substrate all parts of which the desmear solution used for said desmear f makes a contact with and acts on are a surface of insulating resin. Also for such resin substrate, the whole surface of which is coated with an insulating resin material, the desmear method according to the present embodiment allows a smear inside a non-through hole to be certainly removed and allows appropriate surface roughness to be provided, thereby increasing adhesion of the resin substrate to a plating film.

<Examples>

Hereinafter, specific Examples according to the present invention will be described. It should be noted that the present invention is not limited to any of the following Examples.

In the present Examples, there was used a resin substrate obtained by laminating a common insulating resin (ABF-GX13, manufactured by Ajinomoto Fine-Techno Co., Inc.) on a printed circuit board FR-4 having a copper layer as an inner layer, and 50 blind via holes, each having a diameter of 40 μm, were formed in said resin substrate by a laser, and then treatments shown in the following Table 1 were performed.

Moreover, in roughening among steps shown in the following Table 1, each of Examples and Comparative Examples used a desmear solution having the corresponding composition as shown in the following Table 2, and was conducted under the corresponding treatment condition.

[Table 1]

| Step | Chemicals | Temperature (degrees C) | Time (min.) | Remarks |
|---|---|---|---|---|
| Swelling | MDS-37, manufactured by C. Uyemura & Co., Ltd. | 70 | 10 | |
| Roughening | Composite (Refer to Table 2.) | (Table 2) | (Table 2) | |
| Neutralization | MDN-38, manufactured by C. Uyemura & Co., Ltd. | 35 | 5 | |
| Drying | | | | |
| Cleaner | THRU-CUP MCC-6-A, manufactured by C. Uyemura & Co., Ltd. | 50 | 5 | |
| Soft etching | 100 g/L of sodium persulfate | 25 | 1 | |
| | 100 g/L of sulfuric acid | | | |
| Acid pickling | 100 g/L of sulfuric acid | 25 | 1 | |
| Activator | ALCUP MAT-22, manufactured by C. Uyemura & Co., Ltd. | 60 | 5 | |

(continued)

| Step | Chemicals | Temperature (degrees C) | Time (min.) | Remarks |
|---|---|---|---|---|
| Reducer | ALCUP MAB-4-A, manufactured by C. Uvemura & Co., Ltd. | 35 | 3 | |
| | ALCUP MAB-4-C, manufactured by C. Uyemura & Co., Ltd. | | | |
| Accelerator | THRU-CUP MEL-3-A, manufactured by C. Uyemura & Co., Ltd. | 25 | 1 | |
| Electroless copper plating | THRU-CUP PEA Ver.2, manufactured by C. Uyemura & Co., Ltd. | 36 | 15 | |
| Drying | | | | |
| Heat treatment | | 150 | 30 | |
| Cleaner | THRU-CUP MSC-3-A, manufactured by C. Uyemura & Co., Ltd. | 40 | 5 | |
| Acid pickling | 100 g/L of sulfuric acid | 25 | 1 | |
| Electro copper plating | THRU-CUP ETN, manufactured by C. Uyemura & Co., Ltd. | 25 | 45 | 2.5A/dm$^2$ 25-$\mu$m Cu thickness |
| Discoloration prevention | THRU-CUP AT-21, manufactured by C. Uyemura & Co., Ltd. | 25 | 1 | |
| Drying | | | | |
| Heat treatment | | 180 | 60 | |

[Table 2]

| | Sodium permanganate concentration (mol/L) | Sodium hydroxide concentration (mol/L) | Temperature (degrees C) | Time (min.) |
|---|---|---|---|---|
| Example 1 | 0.30 | 2.7 | 70 | 15 |
| Example 2 | 0.30 | 1.8 | 75 | 15 |
| Example 3 | 0.30 | 3.2 | 70 | 15 |
| Example 4 | 0.30 | 5.0 | 70 | 15 |
| Example 5 | 0.25 | 3.0 | 70 | 15 |
| Example 6 | 0.25 | 4.0 | 70 | 15 |
| Example 7 | 0.35 | 4.0 | 70 | 15 |
| Example 8 | 0.35 | 6.0 | 70 | 15 |
| Comparative Example 1 | 0.30 | 1.0 | 80 | 15 |
| Comparative Example 2 | 0.50 | 2.7 | 70 | 15 |
| Comparative Example 3 | 0.10 | 2.7 | 70 | 15 |
| Comparative Example 4 | 0.50 | 1.0 | 80 | 15 |
| Comparative Example 5 | 0.10 | 1.5 | 80 | 15 |

Peel strength, surface roughness (Ra), a resin reduction amount, smear residues in the bottom of a via hole, and an amount of hexavalent manganese formed after treatment, of a substrate which had undergone the above steps were evaluated. It should be noted that each evaluation was performed using the corresponding apparatus and the like shown below.

Peel strength: A 1-cm-wide slit was made in the substrate, and, in accordance with JIS-C5012, peel strength thereof was evaluated using AUTOGRAPH AGS-X, manufactured by Shimadzu Corp.

Surface roughness (Ra) measurement: Surface roughness (Ra) was measured using a laser microscope (VK-8550), manufactured by KEYENCE CORP.

Resin reduction amount: A resin reduction amount was calculated by weight measurement before and after the desmear treatment.

Confirmation of smear residues in the bottom of via holes: Among 50 via holes, the number of via holes in which a smear remained was counted.

Formation amount of hexavalent manganese: An amount of hexavalent manganese formed in the desmear solution after treatment of a 1-dm$^2$ resin substrate was measured using an ultraviolet spectrophotometer (UV-2450), manufactured by Shimadzu Corp.

The following Table 3 collectively shows evaluation results of each of Examples and Comparative Examples.

[Table 3]

| | Peel strength (gf/cm) | Ra (μm) | Resin reduction amount (mg/dm$^2$) | Number of via holes having smear residues in the bottom (among 50 via holes) | Amount of hexavalent Mn formed after treatment of 1dm$^2$ resin substrate (g) |
|---|---|---|---|---|---|
| Example 1 | 850 | 0.4 | 25 | 0 | 0.35 |
| Example 2 | 720 | 0.4 | 20 | 0 | 0.28 |
| Example 3 | 865 | 0.5 | 35 | 0 | 0.49 |
| Example 4 | 859 | 0.6 | 45 | 0 | 0.59 |
| Example 5 | 780 | 0.4 | 22 | 0 | 0.31 |
| Example 6 | 790 | 0.5 | 33 | 0 | 0.46 |
| Example 7 | 820 | 0.6 | 39 | 0 | 0.55 |
| Example 8 | 840 | 0.6 | 50 | 0 | 0.62 |
| Comparative Example 1 | 750 | 0.7 | 43 | 12 | 0.72 |
| Comparative Example 2 | 820 | 0.7 | 46 | 0 | 0.75 |
| Comparative Example 3 | 420 | 0.4 | 15 | 38 | 0.25 |
| Comparative Example 4 | 780 | 0.7 | 45 | 0 | 0.75 |
| Comparative Example 5 | 350 | 0.3 | 12 | 42 | 0.20 |

As shown in the results in Table 3, in Examples 1 to 8, wherein a permanganate had a concentration of 0.2 to 0.4 mol/L, an amount of an alkali metal hydroxide contained was larger than an amount of the permanganate contained, and a molar concentration ratio of the permanganate to the alkali metal hydroxide was 1:5 to 1:20, smears were completely removed and also appropriate surface roughness was provided without excessive roughening of the surface of a resin substrate, whereby peel strength of a plating film was higher. Furthermore, it was found that a resin reduction amount was kept small and therefore excessive etching did not progress in the depth direction of the resin. Furthermore, since excessive etching was controlled and accordingly a resin reduction amount was smaller, a production amount of hexavalent manganese was smaller.

On the other hand, in Comparative Example 1, in spite of the fact that the temperature was set higher, many smears remained, surface roughness was higher, that was 0.7, a resin reduction amount was larger, and the resin was excessively roughened, including in the depth direction of the resin. Furthermore, following this, a plating film had a weaker peel strength and a poor adhesion. Also, excessive etching occurred, thereby excessively roughening the resin, and accordingly a production amount of hexavalent manganese was very large, that was 0.72.

In Comparative Examples 2 and 4, smears were completely removed, but the permanganate was made to have a higher concentration, whereby surface roughness was higher, that was 0.7, a resin reduction amount was larger, and the resin was excessively roughened, including in the depth direction of the resin. Furthermore, following this, a plating film had insufficient peel strength. Also, excessive etching occurred, thereby excessively roughening the resin, and accordingly a production amount of hexavalent manganese was very large, that was 0.75.

In Comparative Examples 3 and 5, the permanganate was made to have a concentration of 0.1 mol/L, whereby surface roughness was lower and a resin reduction amount was smaller, a surface of the resin was not excessively roughened, and a production amount of hexavalent manganese was smaller, however, appropriate surface roughness was not be provided, and also a plating film had a remarkably weak peel strength. Furthermore, most of smears remained.

Reference Signs List

10    insulating resin,

20    plating film,

30    carbon layer, and

40    filler.

**Claims**

1.  A desmear solution, containing :

    a permanganate having a concentration of 0.2 to 0.4 mol/L and
    an alkali metal hydroxide,

    **characterized in that** a molar concentration ratio of said permanganate to said alkali metal hydroxide is 1:5 to 1:20.

2.  The desmear solution according to claim 1, wherein the above-mentioned molar concentration ratio is 1:10 to 1:20.

3.  The desmear solution according to claim 1, wherein the above-mentioned alkali metal hydroxide is sodium hydroxide.

4.  Use of the desmear solution according to claim 1, wherein the desmear solution being used for a desmear treatment for a resin substrate having a non-through hole formed therein.

5.  Use of the desmear solution according to claim 4, wherein a whole surface of the above-mentioned resin substrate except a surface of the formed non-through hole is coated with resin.

6.  A desmear method for a resin substrate having a non-through hole formed therein,
    wherein a desmear treatment is performed using a desmear solution,
    the desmear solution comprising a permanganate having a concentration of 0.2 to 0.4 mol/L and an alkali metal hydroxide, and having a molar concentration ratio of said permanganate to said alkali metal hydroxide of 1:5 to 1:20.

7.  The desmear method according to claim 6, wherein the above-mentioned resin substrate is given a swelling treatment and then made in contact with the above-mentioned desmear solution.

8.  The desmear method according to claim 6, wherein a whole surface of the above-mentioned resin substrate except a surface of the formed non-through hole is coated with resin.

**Patentansprüche**

1. Desmear-Lösung, enthaltend:

   ein Permanganat mit einer Konzentration von 0,2 bis 0, 4 mol/l und
   ein Alkalimetallhydroxid,

   **dadurch gekennzeichnet, dass** ein Stoffmengenkonzentrationsverhältnis des Permanganat zum Alkalimetallhydroxid 1:5 bis 1:20 ist.

2. Desmear-Lösung nach Anspruch 1, wobei das oben erwähnte Stoffmengenkonzentrationsverhältnis 1:10 bis 1:20 ist.

3. Desmear-Lösung nach Anspruch 1, wobei das oben erwähnte Alkalimetallhydroxid Natriumhydroxid ist.

4. Verwendung der Desmear-Lösung nach Anspruch 1, wobei die Desmear-Lösung für eine Desmear-Behandlung für ein Harzsubstrat mit einem darin ausgebildeten nicht durchgehenden Loch verwendet wird.

5. Verwendung der Desmear-Lösung nach Anspruch 4, wobei eine ganze Oberfläche des oben erwähnten Harzsubstrats ausgenommen eine Oberfläche des ausgebildeten nicht durchgehenden Lochs mit Harz beschichtet ist.

6. Desmear-Verfahren für ein Harzsubstrat mit einem darin ausgebildeten nicht durchgehenden Loch,
   wobei eine Desmear-Behandlung unter Verwendung einer Desmear-Lösung durchgeführt wird,
   wobei die Desmear-Lösung ein Permanganat mit einer Konzentration von 0,2 bis 0,4 mol/l und ein Alkalimetallhydroxid aufweist und ein Stoffmengenkonzentrationsverhältnis des Permanganat zum Alkalimetallhydroxid von 1:5 bis 1:20 aufweist.

7. Desmear-Verfahren nach Anspruch 6, wobei das oben erwähnte Harzsubstrat einer Quellbehandlung unterzogen und dann mit der oben erwähnten Desmear-Lösung in Kontakt gebracht wird.

8. Desmear-Verfahren nach Anspruch 6, wobei eine ganze Oberfläche des oben erwähnten Harzsubstrats ausgenommen eine Oberfläche des ausgebildeten nicht durchgehenden Lochs mit Harz beschichtet ist.


**Revendications**

1. Solution de décapage, contenant :

   un permanganate présentant une concentration de 0,2 à 0,4 mole/l et
   un hydroxyde de métal alcalin,

   **caractérisée en ce qu'**un rapport de concentrations molaires dudit permanganate sur ledit hydroxyde de métal alcalin est de 1/5 à 1/20.

2. Solution de décapage selon la revendication 1, dans laquelle le rapport de concentrations molaires susmentionné est de 1/10 à 1/20.

3. Solution de décapage selon la revendication 1, dans laquelle l'hydroxyde de métal alcalin susmentionné est l'hydroxyde de sodium.

4. Utilisation de la solution de décapage selon la revendication 1, dans laquelle la solution de décapage est utilisée pour un traitement de décapage pour un substrat en résine dans lequel un trou non débouchant est formé.

5. Utilisation de la solution de décapage selon la revendication 4, dans laquelle une surface entière du substrat en résine susmentionné, sauf une surface du trou non débouchant formé, est recouverte avec une résine.

6. Procédé de décapage pour un substrat en résine dans lequel un trou non débouchant est formé,
   dans lequel un traitement de décapage est mis en oeuvre en utilisant une solution de décapage,
   la solution de décapage comprenant un permanganate présentant une concentration de 0,2 à 0,4 mole/l et un hydroxyde de métal alcalin, et présentant un rapport de concentrations molaires dudit permanganate sur ledit hydroxyde de métal alcalin de 1/5 à 1/20.

7. Procédé de décapage selon la revendication 6, dans lequel le substrat en résine susmentionné est soumis à un traitement de gonflement et est ensuite mis en contact avec la solution de décapage susmentionnée.

8. Procédé de décapage selon la revendication 6, dans lequel une surface entière du substrat en résine susmentionné, sauf une surface du trou non débouchant formé, est recouverte avec une résine.

**FIG. 1A**

**FIG. 1B**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004282020 A
- JP 2001135750 A
- US 4592852 A
- GB 1479556 A